# EUROPÄISCHE PATENTANMELDUNG

(11) **EP 1 306 415 A2**
(43) Veröffentlichungstag der Anmeldung: **02.05.2003**
(21) Anmeldenummer: 02022977.9
(22) Anmeldetag: 14.10.2002
(51) Int. Cl.: C09G 1/02, C09K 3/14, H01L 21/321

(54) **Zusammensetzung für das chemisch-mechanische Polieren von Metall- und Metall-Dielektrikastrukturen mit hoher Selektivität**

(30) Priorität: 26.10.2001 DE 10152993
(71) Anmelder: Bayer Aktiengesellschaft, 51368 Leverkusen (DE)
(72) Erfinder: Puppe, Lothar, Dr., 51399 Burscheid (DE); Passing, Gerd, Dr., 50354 Hürth (DE); Vogt, Kristina, Dr., 53797 Lohmar (DE); Terzieva, Valentina, Dr., 3001 Heverlee (BE)

(57) **Zusammenfassung**

Eine Zusammensetzung für das chemisch-mechanische Polieren von Metall- und Metall/Dielektrika-Strukturen enthaltend 7 bis 100 Vol.-% eines kationisch stabilisierten 30 Gew.-% SiO₂ enthaltenden Kieselsols, dessen SiO₂-Partikel eine mittlere Teilchengröße kleiner als 300 nm haben, mit einem pH-Wert von 4 bis 10, zeichnet sich durch eine TaN-Abtragsrate ≥ 40 nm pro Min. und eine verbesserte Selektivität von Barriereschicht : Metall von mindestens 2 : 1 oder größer und einer Selektivität von Barriereschicht : Dielektrium von mindestens 2 : 1 oder größer aus.

## Beschreibung

Die vorliegende Erfindung betrifft eine Zusammensetzung für das chemisch-mechanische Polieren (CMP) von Metall- und Metall/Dielektrikastrukturen, ein Verfahren zu ihrer Herstellung und ihre Verwendung.

Integrierte Halbleiterschaltungen (IC) bestehen aus strukturierten halbleitenden, nichtleitenden und elektrisch leitfähigen dünnen Schichten. Diese strukturierten Schichten werden üblicherweise dadurch hergestellt, dass ein Schichtmaterial, z. B. durch Aufdampfen aufgebracht und durch ein mikrolithographisches Verfahren strukturiert wird. Durch die Kombination der verschiedenen halbleitenden, nicht leitenden und leitenden Schichtmaterialien werden die elektronischen Schaltungselemente des IC, wie z. B. Transistoren, Kondensatoren, Widerstände und Verdrahtungen erzeugt.

Die Qualität eines IC und seiner Funktion hängt in entscheidendem Maße von der Präzision ab, mit der die verschiedenen Schichtmaterialien aufgebracht und strukturiert werden können.

Mit steigender Schichtenanzahl nimmt jedoch die Planarität der Schichten deutlich ab. Dies führt ab einer bestimmten Schichtenanzahl zum Versagen einer oder mehrerer Funktionselemente des IC und damit zum Versagen des gesamten IC.

Die Verringerung der Planarität der Schichten ist Folge des Aufbaus neuer Schichten, wenn diese auf bereits strukturierte Schichten aufgebracht werden müssen. Durch die Strukturierung entstehen Höhenunterschiede, die bis zu 0,6 µm pro Schicht betragen können. Diese Höhenunterschiede addieren sich von Schicht zu Schicht und bewirken, dass die darauffolgende Schicht nicht mehr auf eine planare sondern auf eine unebene Fläche aufgebracht werden muss. Eine erste Folge ist, dass die nachfolgend aufgebrachte eine ungleichmäßige Dicke aufweist. In extremen Fällen entstehen so Fehlstellen, Defekte in den elektronischen Funktionselementen und mangelnde Kontakte. Unebene Flächen führen zudem zu Problemen bei der Strukturierung. Um ausreichend kleine Strukturen erzeugen zu können, ist eine extrem hohe Abbildungsgenauigkeit (DOF, depth of focus) im mikrolithographischen Verfahrensschritt notwendig. Diese Strukturen können jedoch nur in einer Ebene scharf abgebildet werden; je stärker Stellen von dieser Ebene abweichen, desto unschärfer ist die Abbildung.

Zur Lösung dieses Problems wird ein sogenanntes chemisch-mechanisches Polieren (CMP) durchgeführt. Das CMP bewirkt eine globale Planarisierung der strukturierten Oberfläche durch Abtrag erhöhter Schichtteile, bis eine ebene Schicht erhalten wird. Hierdurch kann der nächstfolgende Schichtaufbau auf einer ebenen Fläche ohne Höhenunterschiede erfolgen, und die Präzision der Strukturierung und die Funktionsfähigkeit der Elemente des IC bleiben erhalten.

Ein CMP-Schritt wird mit Hilfe von speziellen Poliermaschinen, Poliertüchern (Pads) und Poliermitteln (Polierslurries) durchgeführt. Eine Polierslurry ist eine Zusammensetzung, die in Kombination mit dem Poliertuch, dem sogenannten Pad auf der Poliermaschine einen Abtrag des zu polierenden Materials bewirkt.

Ein Wafer ist eine polierte Siliciumscheibe, auf der integrierte Schaltungen aufgebaut werden.

Eine Übersicht über die Technik des CMP findet sich z.B. in B. L. Mueller, J. S. Steckenrider Chemtech (1998) S. 38 - 46.

Insbesondere in Polierschritten, in denen Halbleiterschichten beteiligt sind, sind die Anforderungen an die Präzision des Polierschrittes und damit an die Polierslurry besonders groß.

Bewertungsmaßstab für die Wirksamkeit von Polierslurries sind eine Reihe von Größen, mit denen die Wirkung der Polierslurry charakterisiert wird. Hierzu gehören die Abtragsrate, d.h. die Geschwindigkeit mit der das zu polierende Material abgetragen wird, die Selektivität, d.h. das Verhältnis der Abtragsgeschwindigkeiten von zu polierenden Material zu weiteren anwesenden Materialien, sowie Größen für die Gleichmäßigkeit der Planarisierung. Als Größen für die Gleichmäßigkeit der Planarisierung werden üblicherweise die Gleichmäßigkeit der Restschichtdicke innerhalb eines Wafers (WIWNU) und die Gleichmäßigkeit von Wafer zu Wafer (WTWNU) sowie die Anzahl der Defekte pro Flächeneinheit verwendet.

Für die Herstellung von integrierten Schaltungen (Integrated Circuits, IC) wird zunehmend der sogenannte Cu-Damascene-Prozess verwendet (vgl. z.B. "Microchip Fabrication: A Practical Guide to Semiconductor Processing", Peter Van Zant, 4^{th} Ed., McGraw-Hill, 2000, S. 401 - 403 und 302 - 309 und "Copper CMP: A Question of Tradeoffs", Peter Singer, Semiconductor International, Verlag Cahners, Mai 2000, S. 73 - 84). Dabei ist es erforderlich, eine Cu-Schicht chemisch-mechanisch mit Hilfe einer Polierslurry abzutragen (sog. Cu-CMP-Prozess), um die Cu-Leiterbahnen herzustellen. Die fertigen Cu-Leiterbahnen sind in ein Dielektrikum eingebettet. Zwischen Cu und dem Dielektrikum befindet sich eine Barriereschicht. Bekannt für den Cu-CMP-Prozess ist ein Zwei-Schritt Prozess. D. h., dass die Cu-Schicht zuerst mit einer Polierslurry poliert wird, die einen hohen Cu-Abtrag garantiert. Anschließend wird eine zweite Polierslurry verwendet, um die endgültige ebene Oberfläche mit dem glatt und blank polierten Dielektrikum und den eingebetteten Leiterbahnen herzustellen.

Für den ersten Polierschritt verwendet man eine Polierslurry mit hoher Selektivität, d. h., dass die Abtragsrate für Cu möglichst hoch ist und die für das Material der darunter liegenden Barriereschicht möglichst niedrig ist. Der Polierprozess wird automatisch gestoppt, sobald unter dem Cu die Barriereschicht freigelegt wird. Da das komplette Entfernen von Cu-Resten auf der Barriereschicht einige Zeit dauert (sogenanntes "over polishing"), wird an den Stellen, wo sich im Dielektrikum die eingebetteten Cu-Leiterbahnen befinden, in dieser Zeit das Cu der Leiterbahn weiterhin stark abgetragen. Dieser Effekt wird "dishing" genannt. Für den zweiten Polierschritt verwendet man daher, je nach Konzept bzw. Qualität der im ersten Polierschritt erhaltenen Oberfläche, eine Polierslurry, die selektiv oder nicht selektiv ist bezüglich der zu polierenden Materialien Cu, Barriereschicht und Dielektrikum.

Kann man im ersten Schritt einen gleichmäßigen Cu-Abtrag mit nur geringen Resten von Cu auf der Barriereschicht erreichen, so ist es vorteilhaft, für den zweiten Schritt eine für die Barriereschicht hochselektive Slurry einzusetzen, um eine gleichmäßig polierte Oberfläche zu erhalten.

Wird dagegen im ersten Polier-Schritt eine Oberfläche erzeugt, die noch Cu auf der Barriereschicht enthält, ist der Einsatz einer für die Barriereschicht nicht-selektiven Polierslurry angezeigt. Bei Verwendung einer nicht selektiven Polierslurry, d.h. bei annähernd gleicher Abtragsrate für Cu, Barriereschicht und Dielektrikum, wird die gesamte Waferoberfläche durch den Polierprozess gleichmäßig eingeebnet (planarisiert). Bei diesem Konzept muss ein Teil der Dielektrikaschicht geopfert werden, was wegen der notwendigen Abscheidung dickerer Dielektrika- und Cu-Schichten nachteilig ist. Wesentlich bei Verwendung der nicht selektiven Polierslurry ist, dass die Polierslurry eine für alle drei zu polierenden Materialien die gleiche Planarisierungseffizienz haben muss. Außerdem müssen die hergestellten Cu-Leiterbahnen eine Mindestdicke aufweisen, d. h. es darf nicht zu viel von der Dielektrikaschicht und den Cu-Leiterbahnen abgetragen werden, was während des Polierprozesses kontrolliert werden muss.

Bei Verwendung einer selektiven Polierslurry für den zweiten Schritt ist die Abtragsrate für die Barriereschicht höher als die für das Cu. Bei diesem Konzept wird durch das gezielte Abtragen der Barriereschicht das sogenannte "dishing" der Cu-Leiterbahnen verringert. Der Verlust an Dielektrikum (Erosion) und damit einhergehend der Cu-Leiterbahn-Schichtdicke ist daher geringer.

Aus dem Stand der Technik sind bereits Polierslurries mit selektiven Abtragsraten bekannt. So offenbart die WO-A-99/64527 in Beispiel 3 eine Polierslurry auf Basis von Kieselsol mit 2 Gew.-% H₂O₂ und einem pH-Wert von 10,5 die eine Selektivität für Cu : Ta : Dielektrikum (hier ein SiO₂, auch Oxid genannt) von 1 : 1,6 : 4 aufweist. Diese bekannte Polierslurry führt jedoch zu einem sehr starken Abtrag des Oxids, sobald die Barriereschicht abpoliert ist, und damit zu einer unebenen Waferoberfläche. Die sogenannte "oxide erosion" wird sogar verstärkt. Der Begriff "oxide erosion" wird in "Copper CMP: A Question of Tradeoffs", Peter Singer, Semiconductor International, Verlag Cahners, Mai 2000, pp 73 - 84 erläutert.

Aus WO-A- 00/00567, Beispiel 3, Nr. 3 ist eine Polierslurry mit Aluminiumoxid als Schleifmittel (Abrasiv) bekannt. Hiermit wird ein Selektivitätsverhältnis Cu : Ta : Oxid von 1 : 4,5 : 2 erzielt, mit dem die "oxide erosion" zwar vermieden werden kann, nachteilig an dieser Polierslurry ist jedoch die niedrige Abtragsrate für die Barriereschicht aus Ta von 300 Å/min, die den Produktionsprozess verlangsamt, und die hohe Härte des Aluminiumoxids, was verstärkt zu Kratzern auf der Waferoberfläche führt.

Die EP-A-1 069 168 beschreibt beispielsweise für Cu : TaN : SiO₂ Selektivitäten von 1 : 1,04 : 0,042. Hier ist der Abtrag für das SiO₂ zu niedrig, was zum "dishing" beim Cu führt. Außerdem ist noch ein Abtrags-Verstärker notwendig.

Es ist weiterhin bekannt, bestimmte Zusätze der Polierslurry beizufügen, um die Abtragsraten der Metalle zu erhöhen, bzw. um die Selektivität der Polierslurry einzustellen. Hier sind Oxidationsmittel, Carboxylsäuren und Komplexbildner bekannt. Aus WO-A-99/64527 und WO-A-99/67056 ist bekannt, dass Kieselsole im basischen Medium hohe Oxidabtragsraten bewirken, was bei der reinen Oxidpolierung Stand der Technik ist. WO-A-99/64527 setzt Polyvinylpyrrolidone (PVP) der Polierslurry zu, um die Oxidabtragsrate zu senken.

Die vorbeschriebenen Polierslurries weisen allesamt den Nachteil auf, dass die Selektivitäten, insbesondere die von Cu : Oxid, über den Zusatz von z. B. Filmbildnern oder organischen Verbindungen eingestellt werden müssen und die vom Abrasiv und pH-Wert vorgegebene Cu : Oxid-Selektivität nicht geeignet ist.

Weiterhin enthalten alle vorbekannten Polierslurries H₂O₂ oder andere Oxidationsmittel, um die Abtragsraten der Metalle zu erhöhen.

Es bestand daher die Aufgabe, eine gegenüber dem Stand der Technik verbesserte Polierslurry bereitzustellen mit einer zufriedenstellenden Abtragsrate für die Barriereschicht und mit einer Selektivität von Barriereschicht: Metall von mindestens 2 : 1 oder größer und einer Selektivität von Barriereschicht : Dielektrium von mindestens 2 : 1 oder größer, die vorzugsweise ohne Zusatz von Oxidationsmitteln eingesetzt werden kann.

Überraschenderweise wurde nun gefunden, dass diese Aufgabe mit einer Zusammensetzung gelöst wird, die ein kationisch stabilisiertes Kieselsol mit einem mittleren Teilchendurchmesser <300 nm als Abrasiv enthält.

Gegenstand der Erfindung ist daher eine Zusammensetzung enthaltend 7 bis 100 Vol.-% eines kationisch stabilisierten 30 Gew.-% SiO₂ enthaltenden Kieselsols, dessen SiO₂-Partikel eine mittlere Teilchengröße kleiner als 300 nm haben, mit einem pH-Wert von 4 bis 10 und weniger als 0,05 Gew.-% Oxidationsmittel.

Unter der mittleren Teilchengröße ist hier der Teilchengrößendurchmesser bei d₅₀ zu verstehen, wie er mit der Ultrazentrifuge bestimmt wird.

Für die Messung der Teilchengrößen im Nanometerbereich sind neben Elektronenmikroskopaufnahmen noch weitere verschiedene Methoden geeignet wie z.B. Laserkorrelationsspektroskopie, Ultraschallmessungen oder Messungen mit einer Ultrazentrifuge (H.G. Müller, Cooloid & Polymer Science 267 (1989) S. 1113). Die Ultrazentrifuge ist aufgrund ihrer hohen Trennschärfe besonders gut geeignet Teilchengrößenverteilungen abzubilden.

Der pH-Wert der erfindungsgemäßen Zusammensetzung liegt im Bereich von 4 bis 10. Bevorzugt ist der Bereich von 5 bis 9 und ganz besonders bevorzugt der Bereich von 6 bis 8. Die angegebenen pH Werte beziehen sich auf eine Temperatur von 25°C. Der pH-Wert der Zusammensetzung wird bevorzugt durch Zugabe einer Base zu der Zusammensetzung eingestellt. Die Menge an Base richtet sich dabei nach dem gewünschten pH-Wert. Als Base geeignet sind beispielsweise KOH, NH₄OH, TMAH, Guanidin, Guanidincarbonat, K₂CO₃ oder ähnliche nicht Na-haltige Basen, bevorzugt ist die Verwendung von Kaliumhydroxid. Vorzugsweise wird die Base in Form einer wässrigen Lösung zugegeben. Insbesondere bevorzugt ist die Zugabe einer wäßrigen Lösung von Kaliumhydroxid. Die erfindungsgemäße Zusammensetzung enthält besonders bevorzugt 0,001 bis 30 g/l Kaliumhydroxid (100-%ig).

Im Sinne der vorliegenden Erfindung gelten folgende Begriffsbestimmungen:

Der Begriff Metall umfasst z.B. die Elemente W, Al, Cu, Si, Ru, Pt und Ir und/oder deren Legierungen sowie Carbide.

Der Begriff Dielektrikum umfasst z.B. organische und nicht organische Dielektrika. Beispiele für organische Dielektrika sind SiLK™ der Dow Chemical Company, Polyimide, fluorierte Polyimide, diamantartige Kohlenstoffe, Polyarylether, Polyarylene, Parylen N, Cyclotene, Polynorbonene und Teflon. Nichtorganische Dielektrika basieren z. B. auf SiO₂-Glas als Hauptbestandteil. Nebenbestandteile können Kohlenstoff, Fluor-, Phosphor- und/oder Bor-Verbindungen sein. Gebräuchliche Bezeichnungen für diese Dielektrika sind z. B. FSG, PSG, BSG oder BPSG, wobei SG für "spin on glass" steht. Für die Herstellung dieser Schichten sind verschiedene Herstellungsverfahren bekannt vgl. z.B. (Peter Van Zant, 4^{th} ed., McGraw-Hill, 2000, pp 363 - 376 und pp 389 - 391). Außerdem sind Silsesquioxane (HSQ, MSQ) als Dielektrika bekannt, die stark polymerisiert sind und dem anorganischen Zustand angenähert wurden.

Der Begriff Barriereschicht umfasst z.B. Schichten aus Ta, TaSi, TaN, TaSiN, Ti, TiN, WN, WSiN, SiC, Siliciumoxinitrid, Siliciumoxicarbid, Siliciumoxicarbonitrid, Si₃N₄ und/oder Siliciumoxid.

Für die Herstellung von integrierten Schaltungen bevorzugt ist die Verwendung von Ta und TaN als Barriereschicht.

Für die Herstellung von Leiterbahnen für integrierte Schaltungen werden vorzugsweise Metalle wie Cu, Al oder W verwendet.

Als Dielektrika findet bevorzugt SiO₂ und modifizierte SiO₂-Gläser Verwendung.

Kieselsol im Sinne der Erfindung ist ein Sol, dessen kolloidale SiO₂-Partikel kationisch stabilisiert sind. Vorzugsweise handelt es sich bei den Kationen um H⁺ und/oder K⁺-Ionen. Die Primärpartikel des Kieselsols sind nicht aggregiert. Die mittlere Teilchengröße der SiO₂-Partikel im erfindungsgemäß einzusetzenden Kieselsol ist kleiner als 300 nm. Bevorzugt liegt die mittlere Teilchengröße bei einem Wert von 20 bis 100 nm, besonders bevorzugt bei 30 bis 80 nm. Die erfindungsgemäße Zusammensetzung enthält 7 bis 100 Vol.-%, vorzugsweise 10 bis 80 Vol.-% und besonders bevorzugt 17 bis 70 Vol.-% eines 30 Gew.-% SiO₂ enthaltenden Kieselsols, entsprechend einem Absolutwert von 2 bis 30 Gew.-% SiO₂, vorzugsweise 3 bis 24 Gew.-% SiO₂, besonders bevorzugt 5 bis 21 Gew.-% SiO₂ bezogen auf die Zusammensetzung.

Ein H⁺-stabilisiertes Kieselsol hat einen typischen pH-Wert von 1,5 bis 2,5. Bei höheren pH-Werten wird H⁺ durch K⁺ ersetzt, wobei der Übergang fließend ist. Ein Kieselsol mit pH 7 oder größer gilt als K⁺-stabilisiert. Die durch H⁺- und/oder K⁺-Ionen stabilisierten Kieselsole sind bekannt oder können in an sich bekannter Weise hergestellt werden (vergl. z.B. K.K. Iler "The Chemistry of Silica", Wiley & Sons, New York, 1979, S.355-360).

Der erfindungsgemäßen Zusammensetzung können weitere übliche Zusätze wie z.B. Korrosionsschutzmittel für die Metalle zugesetzt werden. Als Korrosionsschutzmittel kommen zum Beispiel Benzotriazol, 6-Tolyltriazol sowie Phosphate in Mengen von 0,0001 bis 10 Gew.-% in Frage.

Der erfindungsgemäßen Zusammensetzung können außerdem Komplexbildner für die Metalle zugesetzt werden, die die Metalle wasserlöslich machen, wie zum Beispiel Zitronensäure oder Citrate, EDTA, NTA, IDS und Aminosäuren in Mengen von 0,001 bis 10 Gew.-%.

Die erfindungsgemäße Zusammensetzung enthält weniger als 0,05 Gew.-% an Oxidationsmitteln. Besonders bevorzugt enthält die erfindungsgemäße Zusammensetzung 0 bis 0,01 Gew.-% an Oxidationsmitteln. Besonders bevorzugt ist die erfindungsgemäße Zusammensetzung frei von Oxidationsmitteln. Als Oxidationsmittel sind alle üblichen Oxidationsmittel anzusehen, insbesondere HNO₃, AgNO₃, CuClO₄, H₂SO₄, H₂O₂, HOCl, KMnO₄, Ammoniumpersulfat, Ammoniumoxalat, Na₂CrO₄, UHP, Eisenperchlorat, -chlorid, -citrat und -nitrat, HIO₃, KIO₃ und HClO₃.

Gegenstand der Erfindung ist weiterhin ein Verfahren zur Herstellung der erfindungsgemäßen Zusammensetzung dadurch gekennzeichnet, dass man ein 30 oder 40 gew.-%iges kationisch stabilisiertes Kieselsol durch Zugabe von Wasser auf einen Feststoffgehalt von 7 bis 100 Vol.-% verdünnt und anschließend unter Rühren durch Zugabe einer ausreichenden Menge an Base einen pH-Wert von 4 bis 10 einstellt.

Wird für die Herstellung der erfindungsgemäßen Zusammensetzung ein mit H⁺-Ionen stabilisiertes Kieselsol eingesetzt, dann kann dieses durch Zugabe von KOH in ein K⁺-stabilisiertes Kieselsol überführt werden. Nach Zugabe von KOH ist das Kieselsol so lange zu rühren, bis sich ein Gleichgewicht der Kationen auf der Kieselsoloberfläche eingestellt hat. Zweckmäßigerweise liegt das KOH in gelöster Form vor.

Der pH-Wert der erfindungsgemäßen Zusammensetzung wird vorzugsweise durch Zugabe von Kaliumhydroxid zum Kieselsol eingestellt. Nach der Zugabe von Kaliumhydroxid wird das Kieselsol so lange gerührt, bis sich der pH-Wert stabilisiert hat. Zur Herstellung von Zusammensetzungen mit einem pH-Wert < 6 wird bevorzugt ein Kieselsol mit einem pH-Wert von 1,5 bis 2,5 verwendet. Zur Herstellung von Zusammensetzungen mit einem pH-Wert > 6 wird bevorzugt ein Kieselsol mit einem pH-Wert von 7 oder größer verwendet.

Die erfindungsgemäßen Zusammensetzungen können als Polierslurry für das chemisch-mechanische Polieren von Metall- und Metall/Dielektrika-Strukturen verwendet werden. Diese neue Verwendung ist ebenfalls Gegenstand der vorliegenden Erfindung. Insbesondere kann die erfindungsgemäße Zusammensetzung als Polierslurry bei der Herstellung von Halbleitern, integrierten Schaltungen und mikroelektromechanischen Systemen Verwendung finden.

Bevorzugt wird die erfindungsgemäße Zusammensetzung als Polierslurry für das chemisch-mechanische Polieren von Metall- und Metall/Dielektrika-Strukturen, insbesondere von integrierten Schaltungen und mikroelektromechanischer Systeme mit Strukturen aus Metall und Dielektrika, die auf Si-Wafern aufgebaut sind, eingesetzt.

Bevorzugt handelt es sich bei den Metallen um W, Al, Cu, Si, Ru, Pt und Ir und/oder deren Legierungen sowie Carbide.

Bevorzugt handelt es sich bei den Dielektrika um SiLK™, Polyimiden, fluorierten Polyimiden, diamantartigen Kohlenstoffen, Polyarylethern, Polyarylenen, Parylen N, Cyclotenen, Polynorbonenen, Teflon, Silsesquioxanen oder SiO₂-Glas oder deren Gemische.

Bevorzugt handelt es sich bei den Metall/Dielektra-Strukturen um solche aus Cu/SiO₂.

Bei der Barriereschicht handelt es sich bei vorzugsweise um Ta oder TaN.

Die erfindungsgemäßen Zusammensetzungen zeichnen sich durch eine Abtragsrate für die Barriereschicht, insbesondere für TaN von ≥ 40 nm pro min und eine Selektivität von Barriereschicht : Metall von mindestens 2 : 1 oder größer und einer Selektivität von Barriereschicht : Dielektrium von mindestens 2 : 1 oder größer aus.

### Beispiele

Die Polierexperimente wurden mit dem Polierer Mecapol 460 der Fa. Steag durchgeführt. Die Polierparameter sind in Tabelle 2 aufgeführt. Es wurden 200 mm Wafer mit Beschichtungen aus Cu, TaN und SiO₂ poliert. Die Cu -Schicht wurde mit 150 nm Cu-Keimen durch Sputtern und anschließendem Elektroplating von 1000 nm Cu erzeugt. Die TaN -Beschichtung wurde durch Sputtern einer 90 nm TaN-Schicht mit einem PVD-Verfahren (physikalische Dampfphasenabscheidung) abgeschieden, das SiO₂ mit einem PVD-Verfahren unter Einsatz von TEOS erzeugt. Cu und TaN Abtragsraten wurden über Widerstandsmessungen der Schichten vor und nach dem Polieren bestimmt.

**Tabelle 2**

| Polierer: | ***MECAPOL 460*** |
|---|---|
| Arbeitsscheiben- (Poliertuch-) Drehzahl | 45 U/min |
| Polierkopf- (Wafer-) Drehzahl | 30 U/min |
| Anpressdruck | 0,48 bar (7.0 psi) |
| Slurry-Flussrate | 180 ml/min |
| Poliertuch | Freudenberg FX9 auf NPST 46 H |
| Rückseitendruck | 0 bar |

### Allgemeine Vorschrift zu Herstellung der Polierslurries:

Aus den in den Beispielen angegebenen Kieselsolen wurden durch Verdünnen mit VE-Wasser und Zugabe von wäßriger KOH (bzw. von verdünnter Schwefelsäure in den Vergleichsbeispielen) Polierslurries mit den angegebenen Feststoffgehalten und pH-Werten hergestellt. Nach der Herstellung der Polierslurries wurden die Wafer direkt poliert.

### Beispiel 1

In dieser Versuchsreihe wurden Polierslurries aus einem Kieselsol (Levasil®50CK / 30 %-V1, Bayer AG) mit einem mittleren Teilchendurchmesser von 80 nm und einem Feststoff-Gehalt von 5 Gew.-% SiO₂ hergestellt. Der pH-Wert wurde durch Zusatz von wäßriger KOH eingestellt.

**Tabelle 3:**

| Konzentration an SiO₂ [Gew.-%] | pH-Wert Abtragsrate nm/min | | | | Selektivitäten | | |
|---|---|---|---|---|---|---|---|
| | | Cu | TaN | SiO₂ | Cu | TaN | SiO₂ |
| 5 | 6 | 8 | 40 | 9 | 1 | 5 | 1,1 |
| 5 | 8 | 9 | 40 | 1 | 1 | 4,4 | 0,025 |
| 5 | 10 | 8 | 60 | 10 | 1 | 7,5 | 0,17 |

### Beispiel 2

In dieser Versuchsreihe wurden Polierslurries aus einem Kieselsol (Levasil®100 K/30%-V1, Bayer AG) mit einem mittleren Teilchendurchmesser von 30 nm und einer Feststoff-Konzentration von 10 Gew.-% SiO₂ hergestellt. Anschließend wurden mit wäßrigen KOH-Lösungen verschiedene pH-Werte von 5 - 8 erhalten und eine Stunde gerührt. Nach der Herstellung der Polierslurries wurden die Wafer direkt poliert. Die Abtragsraten und Selektivitäten sind in Tabelle 4 aufgeführt.

**Tabelle 4**

| Polierslurry Gew.-% SiO₂ | | Abtragsrate / nm/min | | | Selektivität | | |
|---|---|---|---|---|---|---|---|
| | pH | Cu | TaN | SiO₂ | Cu | TaN | SiO₂ |
| 10 | 5 | 5 | 80 | 4 | 1 | 16 | 0,8 |
| 10 | 8 | 5 | 70 | 3 | 1 | 14 | 0,6 |

### Beispiel 3

In dieser Versuchsreihe wurden Polierslurries aus einem Kieselsol (Levasil® 100 CK/30 %-V1, Bayer AG) mit einem mittleren Teilchendurchmesser von 30 nm und einem Feststoff-Gehalt von 20 Gew.-% SiO₂ hergestellt. Anschließend wurden mit wäßrigen KOH-Lösungen verschiedene pH-Werte von 5 - 8 eingestellt und eine Stunde gerührt. Nach der Herstellung der Polierslurries wurden die Wafer direkt poliert. Die Abtragsraten und Selektivitäten sind in Tabelle 4 aufgeführt.

**Tabelle 4**

| Polierslurry Gew.-% SiO₂ | | Abtragsrate / Å/min | | | Selektivität | | |
|---|---|---|---|---|---|---|---|
| | pH | Cu | TaN | SiO₂ | Cu | TaN | SiO₂ |
| 20 | 5 | 17 | 120 | 33 | 1 | 7 | 1,9 |
| 20 | 8 | 5 | 75 | 40 | 1 | 15 | 8 |

### Vergleichsbeispiel 1

In diesem Versuch wurde eine Polierslurry analog dem Beispiel 1 hergestellt. Die Feststoffkonzentration an SiO₂ betrug 5 Gew.-%.

Der pH-Wert wurde mit verd. H₂SO₄ auf 2,2 eingestellt. Nach der Herstellung der Polierslurry wurden die Wafer direkt poliert. Die Abtragsraten und die Selektivitäten sind in Tabelle 5 aufgeführt.

**Tabelle 5**

| Abtragsrate / mn/min | | | Selektivität | | |
|---|---|---|---|---|---|
| Cu | TaN | SiO₂ | Cu | TaN | SiO₂ |
| 12 | 60 | 60 | 1 | 5 | 5 |

Das Vergleichsbeispiel zeigt, dass bei niedrigen pH-Werten nicht die erforderlichen Selektivitäten erreicht werden, der Abtrag von TaN und SiO₂ ist gleich.

### Vergleichsbeispiel 2

In diesem Versuch wurde eine Polierslurry analog Beispiel 2 mit 10 Gew.-% SiO₂ hergestellt. Anschließend wurde verd. H₂SO₄ zugegeben, um einen pH-Wert von 2 zu erhalten. Es wurde danach eine Stunde gerührt. Nach der Herstellung der Polierslurry wurden die Wafer direkt poliert. Die Abtragsraten und die Selektivitäten sind in Tabelle 6 aufgeführt.

**Tabelle 6**

| Abtragsrate / Å/min | | | Selektivität | | |
|---|---|---|---|---|---|
| Cu | TaN | SiO₂ | Cu | TaN | SiO₂ |
| 10 | 70 | 230 | 1 | 7 | 23 |

Aus dem Vergleichsbeispiel ist ersichtlich, dass die Polierslurry bei niedrigem pH von 2 nicht die Selektivitäten aufweist, die bei der Verwendung der erfindungsgemäßen Polierslurries mit höheren pH-Werten gefunden werden. Der Abtrag für SiO₂ ist höher als für TaN.

## Patentansprüche

1. Zusammensetzung enthaltend 7 bis 100 Vol.-% eines kationisch stabilisierten 30 Gew.-% SiO₂ enthaltenden Kieselsols, dessen SiO₂-Partikel eine mittlere Teilchengröße kleiner als 300 nm haben, mit einem pH-Wert von 4 bis 10, und weniger als 0,05 Gew.-% Oxidationsmittel.

2. Zusammensetzung gemäß Anspruch 1, **dadurch gekennzeichnet, dass** das Kieselsol durch H⁺ und/oder K⁺-Ionen stabilisiert ist.

3. Zusammensetzung gemäß wenigstens einem der Ansprüche 1 bis 2, **dadurch gekennzeichnet, dass** die mittlere Teilchengröße der SiO₂-Partikel 20 bis 100 nm beträgt.

4. Zusammensetzung gemäß wenigstens einem der Ansprüche 1 bis 3, **dadurch gekennzeichnet, dass** ihr pH-Wert im Bereich von 5 bis 9 liegt.

5. Zusammensetzung gemäß wenigstens einem der Ansprüche 1 bis 4, **dadurch gekennzeichnet, dass** sie 0 bis 0,01 Gew.-% Oxidationsmittel enthält.

6. Verwendung einer Zusammensetzung gemäß wenigstens einem der Ansprüche 1 bis 5 zum Polieren von Metall- und Metall/Dielektrika-Strukturen.

7. Verwendung gemäß Anspruch 6, **dadurch gekennzeichnet, dass** es sich bei den Metallen um W, Al, Ru, Pt, Ir, Cu, Si und/oder deren Legierungen oder Carbide handelt.

8. Verwendung gemäß Anspruch 6, **dadurch gekennzeichnet, dass** es sich bei den Dielektrika um SiLK™, Polyimiden, fluorierten Polyimiden, diamantartigen Kohlenstoffen, Polyarylethern, Polyarylenen, Parylen N, Cyclotenen, Polynorbonenen, Teflon, Silsesquioxanen oder SiO₂-Glas oder deren Gemische handelt.

9. Verwendung gemäß Anspruch 6 bei der Herstellung von Halbleitern, integrierten Schaltungen und mikroelektromechanischen Systemen.

10. Verfahren zur Herstellung einer Zusammensetzung gemäß Anspruch 1, **dadurch gekennzeichnet, dass** man ein 30 oder 40 gew.-%iges kationisch stabilisiertes Kieselsol, dessen SiO₂-Partikel eine mittlere Teilchengröße kleiner 300 nm haben, durch Zugabe von Wasser auf einen Feststoffgehalt von 7 bis 100 Vol.-% verdünnt und anschließend unter Rühren durch Zugabe einer ausreichenden Menge an Base einen pH-Wert von 4 bis 10 einstellt.
